# EUROPEAN PATENT APPLICATION

(11) **EP 0 689 295 A1**
(43) Date of publication of application: **27.12.1995**
(21) Application number: 95201451.2
(22) Date of filing: 06.06.1995
(51) Int. Cl.: H03M 13/00

(54) **A system comprising an encoder for coding words in a cyclic manner and comprising a decoder for decoding words which have been coded in a cyclic manner and also an encoder, and also a decoder, and also a method, and also an object**

(30) Priority: 14.06.1994 NL 9400965
(71) Applicant: Koninklijke PTT Nederland N.V., NL-2509 CH The Hague (NL)
(72) Inventor: Hekstra, Andries Pieter, NL-2252 KM Voorschoten (NL)

(57) **Abstract**

Systems, known per se, which comprise an encoder for coding words in a cyclic manner and which comprise a decoder for decoding code words add a synchronisation pattern to a code word in order to be able to eliminate the influence of cyclic shifts. This reduces the number of possible messages and sometimes requires bitstuffing. By introducing an alteration at a fixed position, in code words with a minimum mutual distance which is equal to three, it is attained that an initial position of the code word can at all times be generated by detecting and correcting said alteration, so that a proper decoding can take place despite possible cyclic shifts.

## Description

### Background of the invention

The invention relates to a system comprising an encoder provided with encoding means for coding words in a cyclic manner and comprising a decoder provided with decoding means for decoding words which have been coded in a cyclic manner.

Such a system is, inter alia, known through "Theory and practice of error control codes" by R.E. Blahut, 1984, especially pages 137 - 147. Here an encoder is described (see Figure 6.15 on page 138) provided with encoding means for coding words in a cyclic manner and a decoder is described (see Figure 6.17 on page 140) provided with decoding means for decoding words which have been coded in a cyclic manner. Coding words in a cyclic manner, inter alia, has the advantage that a large collection of words which have been coded in a cyclic manner, i.e. code words can be generated in a very simple manner. By having said code words possess a certain minimum mutual distance, it is attained that the errors occurred between coding and decoding can be detected, and possibly be corrected. If this mutual distance between each pair of random code words is, for example, larger than or equal to three, two errors can be detected and one error can be corrected.

Such a prior-art system, inter alia, has the disadvantage that when a channel situated between the encoder and decoder causes a cyclic shift of a code word, said code word consequently converts into in another code word which however also belongs to the aforementioned collection, which after decoding results in a word which is a shift of the original word to be coded.

### Summary of the invention

The object of the invention is, inter alia, providing a system of the kind mentioned in the preamble which despite the cyclic shifts occurring between coding and decoding is capable in regaining an original word to be coded by the encoder in unshifted state after decoding.

To this end the system in accordance with the invention is characterised in that the encoder is provided with first means for introducing at least one alteration in at least one word which has been coded in a cyclic manner, with the decoder being provided with second means for detecting the alteration.

By introducing an alteration at a fixed position in a word which has already been coded in a cyclic manner via the first means in the encoder, in the decoder said alteration can be detected via the second means. When the relationship between the fixed position and the initial position of the word coded in a cyclic manner, i.e. code word, is known the influence of a possible cyclic shift of the code word is reduced to zero by introducing the alteration.

The invention is, inter alia, based on the insight that when original words with a minimum mutual distance which is equal to three are coded in a cyclic manner, one alteration introduced in a coded word can at all times be corrected, and that in case of a cyclic shift of the code word an alteration introduced at a fixed position in a word which has been coded in a cyclic manner will shift along with the entire code word. In case a minimum mutual distance which is equal to five, even two alterations introduced in a code word can at all times be corrected, etc.

It has to be observed that it is known per se to supplement a word which has already been coded in a cyclic manner with a synchronisation pattern which is indicative for an initial position of the code word. Such a synchronisation pattern, however, can reduce the number of different possible messages and sometimes requires bitstuffing, i.e. adding further bits to prevent that the synchronisation pattern also occurs in the code word itself. The system in accordance with the invention offers a solution to the problem of code words shifting in a cyclic manner without the need to add a synchronisation pattern to a code word.

A first embodiment of the system in accordance with the invention is characterised in that the encoder is provided with further encoding means for further coding a word which has been coded in a cyclic manner, with the decoder being provided with further decoding means for further decoding a word which has been coded in a cyclic manner and which after that has been coded further.

By further coding the code word, in which the alteration has already been introduced, in a cyclic manner via the further encoding means in such a way that a correction of for example two or five errors becomes possible, and further decoding the word which has been coded in a cyclic manner and which after that has been coded further in a cyclic manner, via the further decoding means, after which decoding and detecting again takes place via the decoding means and the second means, a system is obtained which both can annul the cyclic shifts of a code word and can, for example, correct two or five errors in a code word.

A second embodiment of the system in accordance with the invention is characterised in that the second means of the decoder are provided with
- still further encoding means for coding in a cyclic manner a word which has been coded in a cyclic manner and which has been decoded by the decoding means,
- comparison means for comparing a word which has been coded in a cyclic manner by the still further encoding means, with a word which has been coded in a cyclic manner and which has been fed into the decoding means, and
- generating means for generating the alteration in response to a comparison result originating from the comparison means.

By virtue of using the still further encoding means which in general will be identical to the encoding means, a code word which has been decoded by the decoding means is again coded in a cyclic manner. The comparison means compare said word, which has been coded again in a cyclic manner after decoding, with the word which has been coded in a cyclic manner before decoding which is fed into the decoding means, which produces the comparison result which is converted into the alteration by the generating means. With such a system in accordance with the invention the influence of cyclic shifts on code words can be annulled by using all sorts of possible decoding means, also those which are only capable of correcting automatically the position of the alteration introduced without at the same time informing the outside world of the alteration concerned.

The invention further relates to an encoder provided with encoding means for coding words in a cyclic manner.

The encoder in accordance with the invention is characterised in that the encoder is provided with first means for introducing at least one alteration in at least one word which has been coded in a cyclic manner, said alteration being indicative for an initial position.

A first embodiment of the encoder in accordance with the invention is characterised in that the encoder is provided with further encoding means for further coding a word which has been coded in a cyclic manner.

The invention still further relates to a decoder provided with decoding means for decoding words which have been coded in a cyclic manner.

The decoder in accordance with the invention is characterised in that the decoder is provided with second means for detecting at least one alteration introduced in at least one word which has been coded in a cyclic manner, which alteration is indicative for an initial position.

A first embodiment of the decoder in accordance with the invention is characterised in that the decoder is provided with further decoding means for further decoding a word which has been coded in a cyclic manner and which after that has been coded further.

A second embodiment of the decoder in accordance with the invention is characterised in that the second means of the decoder are provided with
- still further encoding means for coding in a cyclic manner a word which has been decoded by the decoding means,
- comparison means for comparing a word which has been coded in a cyclic manner by the still further encoding means, with a word which has been coded in a cyclic manner and which has been fed into the decoding means, and
- generating means for generating the alteration which is indicative for an initial position, in response to a comparison result originating from the comparison means.

The invention also relates to a method for assigning, at a sending side, a word which has been coded in a cyclic manner to an object and for detecting, at a receiving side, the word which has been assigned to the object and has been coded in a cyclic manner.

The object of the invention is also to provide a method of the kind mentioned which despite the cyclic shifts occurring between coding and decoding is capable of regaining, after decoding, an original word to be coded in unshifted state.

The method in accordance with the invention is characterised in that the method comprises the following steps of
- coding in a cyclic manner, at the sending side, a word which is to be assigned to the object,
- introducing, at the sending side, at least one alteration in the word which has been coded in a cyclic manner,
- assigning, at the sending side, to the object the word which has been coded in a cyclic manner and which has been provided with the alteration,
- decoding, at the receiving side, the word which has been assigned to the object and which has been coded in a cyclic manner and which has been provided with the alteration, and
- detecting, at the receiving side, the alteration.

By coding in a cyclic manner, at the sending side, such as for example a food store, a word which is to be assigned to an object, such as for example a food can, subsequently introducing an alteration in the code word and after that assigning the word which has been coded in a cyclic manner and which has been provided with the alteration to the object, for example by sticking a label furnished with the code word (provided with the alteration) to the object, said object is identified in a very advantageous manner, at the sending side. At the receiving side, such as for example a point-of-sale, by subsequent detection of the alteration and decoding of the code word or vice versa, the object can be detected automatically, while the cyclic shifts which occurred between coding and decoding can be annulled.

A first embodiment of the method in accordance with the invention is characterised in that the method further comprises the following steps of
- further coding, at the sending side, a word which has been coded in a cyclic manner, and
- further decoding, at the receiving side, a word which has been coded in a cyclic manner and which after that has been coded further.

By coding, at the sending side, the code word, in which the alteration has already been introduced, further in a cyclic manner which makes a correction of for example two or five errors possible, and further decoding, at the receiving side, the word which has been coded in a cyclic manner and which has been coded further in a cyclic manner, after which the decoding and detecting takes place again, a method is obtained which can both annul cyclic shifts of a code word and, for example, correct two or five errors in a code word.

A second embodiment of the method in accordance with the invention is characterised in that the method still further comprises the following steps of
- coding in a cyclic manner, at the receiving side, a decoded word,
- comparing, at the receiving side, a decoded word which has been coded in a cyclic manner, with a word which has been coded in a cyclic manner, and
- generating, at the receiving side, the alteration in response to a comparison result.

By coding again in a cyclic manner a decoded code word, and by comparing said word which has been coded, after decoding, in a cyclic manner, with the word which has been coded, before decoding, in a cyclic manner, and by converting the thus obtained comparison result into the alteration, the influence of cyclic shifts on code words can be annulled by using all kinds of possible decoding means, also those which are only capable of correcting automatically the alteration introduced without at the same time informing the outside world of the position of the alteration concerned.

The invention further also relates to an object provided with a word which has been coded in a cyclic manner in which at least one alteration has been introduced, which alteration is indicative for an initial position.

Such an object is, for example, a postal item which has been provided with a fluorescing bar code.

### References

■ "Theory and practice of error control codes", by R.E. Blahut, 1984, in particular pages 137-147, and Figures 6.15 and 6.17. All references are assumed as being incorporated in this patent application.

### Exemplary embodiment

The invention will now be explained in greater detail by reference of an exemplary embodiment represented in the Figures, in which:
- Figure 1: shows a specific embodiment of an encoder in accordance with the invention,
- Figure 2: shows a specific embodiment of a decoder in accordance with the invention,
- Figure 3: shows a symbolic representation of a general encoder in accordance with the invention, and
- Figure 4: shows a symbolic representation of a general decoder in accordance with the invention.

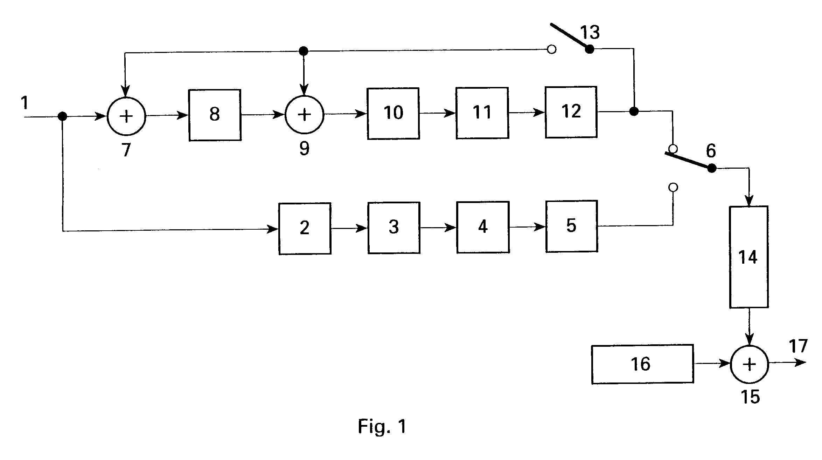

The specific embodiment of an encoder in accordance with the invention shown in Figure 1 comprises an input 1 for receiving an information word to be coded of 11 bits. Input 1 is coupled to a first switch-over contact of a selector switch 6 via four serially connected delay elements 2, 3, 4 and 5, of which switch 6 a main contact is connected to an input of shift register 14. An input thereof is connected to a first input of word adder 15 which adds two words bit by bit without at the same time generating a carry signal or overflow signal. A second input of word adder 15 is connected to a shift register 16 and an input of word adder 15 forms an output 17 of the encoder. Via a (first input of) bit adder 7, a delay element 8, a (first input of) bit adder 9 and three serially connected delay elements 10, 11 and 12, input 1 is further coupled to a second switch-over contact of the selector switch 6, which second switch-over contact is coupled, via a switch 13, to (a second input of) bit adder 7 and to (a second input of) bit adder 9.

The encoder shown in Figure 1 operates as follows. An information word, to be coded in a cyclic manner on the basis on remainder action given the polynomial x⁴ + x + 1, of eleven bits is presented to input 1. During the first fifteen shifts the change-over switch 6 is situated in such a position that the first change-over contact is connected-through to the main contact. As a consequence thereof the information word shifts into the shift register 14 via the delay elements 2, 3, 4 and 5 and the change-over switch 6. Meanwhile switch 13 is in a conductive position. As a result thereof, after fifteen shifts a remainder word of four bits appears in the delay elements 8, 10, 11 and 12, which remainder word is the result of dividing the information word (multiplied by x⁴) of eleven bits by the polynomial x⁴ + x + 1. Subsequently the selector switch 6 is pulled over, with the second change-over contact being connected-through to the main contact, and switch 13 is brought into the non-conducting position, after which for the next four shifts the remainder word shifts into the shift register 14 via the delay elements 8, 10, 11 and 12 and selector switch 6. Thus said shift register 14 after nineteen shifts comprises an information word which has been coded in a cyclic manner, i.e. a code word of fifteen bits. An adding word stored in shift register 16 is then added bit by bit to this code word via word adder 15, without at the same time a carry signal or overflow signal being taken into account. When the adding word, for example, consists of fourteen bits having the value zero and one bit having the value one, said bit having the value one will result in an alteration or inversion of the bit situated in the same position in the code word. As a result of this the code word is provided with the alteration, which indicates, for example, (in a direct manner) the initial position or (in an indirect manner) a fixed relation (a fixed distance) to the initial position. This code word having the alteration introduced therein is subsequently transmitted via output 17. When each pair of code words possess a minimum mutual distance which is equal to the value three, on decoding said one alteration can at all times be detected. As a result of the alteration indicating the initial value directly or indirectly, the code word can still be properly decoded by a decoder, despite possible cyclic shifts which occurred between coding and decoding.

All delay elements could be realised on the basis of, for example, D-flipflops by methods known to those skilled in the art, whereas the bit adders could, for example, be realised with the help of so-called EXOR ports. A parallel embodiment of a word adder then comprises fifteen bit adders, whereas a serial embodiment of a word adder is realised with one bit adder. Introducing the alteration could be accomplished in several alternative manners, such as by reading-out the bit value of the location concerned of the shift register and subsequently again writing-in, via a so-called inverting port, the now inverted bit value on the location concerned. Elements 2 to 13 inclusive in Figure 1 form so-called encoding means, and elements 14, 15 and 16 form so-called first means for introducing at least one alteration in at least one word which has been coded in a cyclic manner. When each pair of code words would possess a minimum mutual distance which is equal to the value five, even two alterations could be introduced, etc.

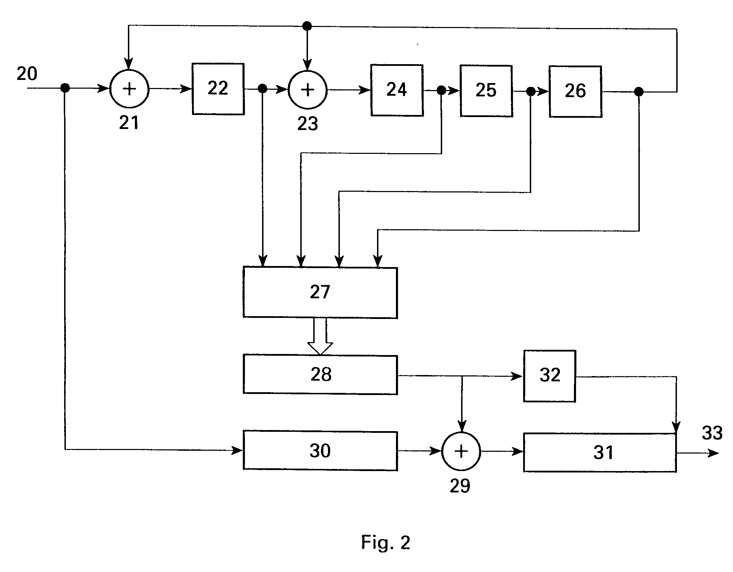

The specific embodiment of a decoder in accordance with the invention and shown in Figure 2 comprises an input 20 which is coupled to a table memory 27 via a serial connection of a (first input of) bit adder 21, a delay element 22, a (first input of) bit adder 23 and three serially connected delay elements 24, 25 and 26, with an output of delay elements 26 being coupled to (a second input of) bit adder 21 and to (a second input of) bit adder 23, and with an output of each delay element 22, 24, 25 and 25 being coupled to an input of table memory 27 for feeding an input word of four bits. In response thereto table memory 27 generates an output word of fifteen bits. This is fed parallelly into shift register 28, of which each shift unit is connected, to this end, to one of the fifteen outputs of table memory 27. An output of shift register 28 is connected to a first input of word adder 29 and to an input of arithmetic unit 32. Input 20 is further coupled to a second input of word adder 29 via a shift register 30, of which word adder an output is connected to an input of shift register 31. A control output of shift register 31 is connected to an input of arithmetic unit 32, and an output of shift register 31 forms an output 33 of the decoder shown in Figure 2.

The operation of the decoder shown in Figure 2 is as follows. A word which has been coded in a cyclic manner, on the basis of remainder action given the polynomial x⁴ + x + 1, i.e. code word of fifteen bits, which word is composed of an information word of eleven bits and a remainder word of four bits, is presented to input 20 and fed into shift register 30. After fifteen shifts the entire code word of fifteen bits is situated in shift register 30, and a remainder word is present in delay elements 22, 24, 25 and 26, which remainder word is calculated by dividing the presented code word (multiplied by x⁴) of fifteen bits by the polynomial x⁴ + x + 1. Said remainder word possesses the value zero if no alteration has been introduced in the encoder and if no error has occurred between coding and decoding. In case of an alteration introduced in the decoder, the remainder word will possess a value different from zero, with the size of the remainder word being decisive for the position of the alteration introduced. In response to the remainder word which is fed as an input word of four bits into table memory 27, table memory 27 generates an output word of fifteen bits, of which all bits possess the value zero if the remainder word possesses a value zero and of which one bit possesses the value one if the remainder word possesses a value different from zero. In this case, the position of said one bit is determined by the size of the value of the remainder word. The output word is fed into the shift register 28 and then added bit by bit to the code word stored in the shift register 30, after which a corrected code word is loaded into shift register 31 via the output of word adder 29. Said corrected code word could, however, have been shifted in a cyclic manner between coding and decoding, which appears from the difference between the position of the alteration introduced in the encoder and the position of said one bit belonging to the output word which possesses the value one. By storing in the arithmetic unit 32 the position of the alteration introduced in the encoder and feeding the output word into said arithmetic unit 32, arithmetic unit 32 can calculate, in a manner known to those skilled in the art, the difference between both positions and, in case of a difference different from zero, proportionally shift the corrected code word stored in the shift register 31 in a cyclic manner. If, for example, the alteration in the encoder has been introduced at position one and the one bit having the value one in the output word is situated at position three, arithmetic unit 32 has to shift in a cyclic manner the corrected code word, stored in shift register 31, viz. 15 - (3 - 1) = 13 positions to one side or 3 - 1 = 2 positions to the other side, in order that the original word of eleven bits can be generated via output 33.

All delay elements could be realised in a manner known to those skilled in the art on the basis of for example D flip-flops, whereas the bit adders could for example be realised with so-called EXOR ports. A parallel embodiment of a word adder then comprises fifteen bit adders, whereas a serial embodiment of a word adder is realised with one bit adder. Correcting the alteration could be accomplished in several alternative manners, such as by reading-out the bit value of the location concerned of the shift register and subsequently again writing-in, via a so-called inverting port, the now inverted bit value on the location concerned. Elements 21 to 32 inclusive, in Figure 2, both form so-called decoding means and so-called second means for detecting the alteration.

The encoder, shown in Figure 1, could be implemented in software form in a kind of BASIC language in the following manner: 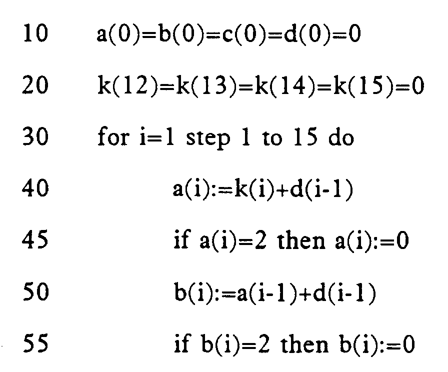 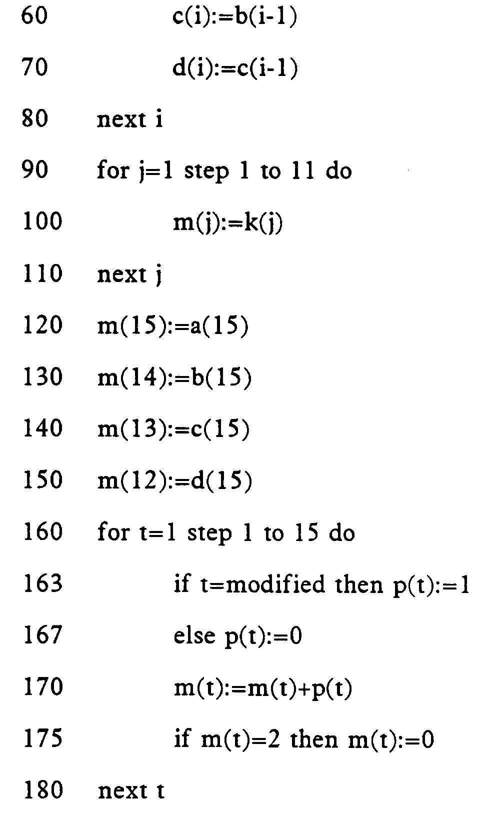
In this connection, a word of eleven bits k(1) to k(11) inclusive which is to be fed into input 1 is coded in a cyclic manner in accordance with the diagram of Figure 1 and thereby converted into a code word of fifteen bits m(1) to m(15) inclusive in which an alteration has been introduced at a fixed position. In this implementation, this alteration is introduced by adding a word of fifteen bits (p(1) to p(15) inclusive with fourteen bits being equal to zero and one bit being equal to one to the obtained code word m(1) to m(15) inclusive.

Before starting, the contents of delay element 8, i.e. a(0), is equal to zero, the contents of delay element 10, i.e. b(0), is equal to zero, the contents of delay element 11, i.e. c(0), is equal to zero, and the contents of delay element 12, i.e. d(0), is equal to zero (line 10). Further the word to be coded k(1) to k(11) inclusive, has to be supplemented by four zeros (line 20). Then, for fifteen shifts the contents of each delay element 8, 10, 11 and 12 is determined (lines 30 to 80 inclusive). The first eleven bits m(1) to m(11) inclusive of the code word stored in shift register 14 are equal to the eleven bits of the word to be coded k(1) to k(11) inclusive, because they are fed via the delay elements 2, 3, 4 and 5 (lines 90 to 110 inclusive). The last four bits m(12) to m(15) inclusive of the code word stored in shift register 12 are equal to the contents of the delay elements 12, 11, 10 and 8 respectively (lines 120 to 150 inclusive). Finally the alteration is introduced ("modified") by adding a word of fifteen bits p(1) to p(15) inclusive which is stored in the shift register 16 to the obtained code word m(1) to m(15) inclusive. In this manner a new code word m(1) to m(15) inclusive is obtained which contains said alteration.

The encoder shown, in Figure 2, could be implemented in software form in a kind of BASIC language in the following manner: 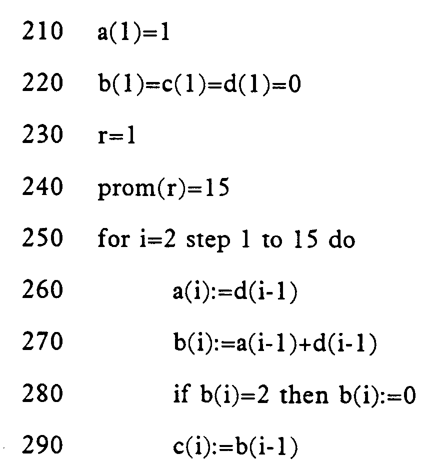 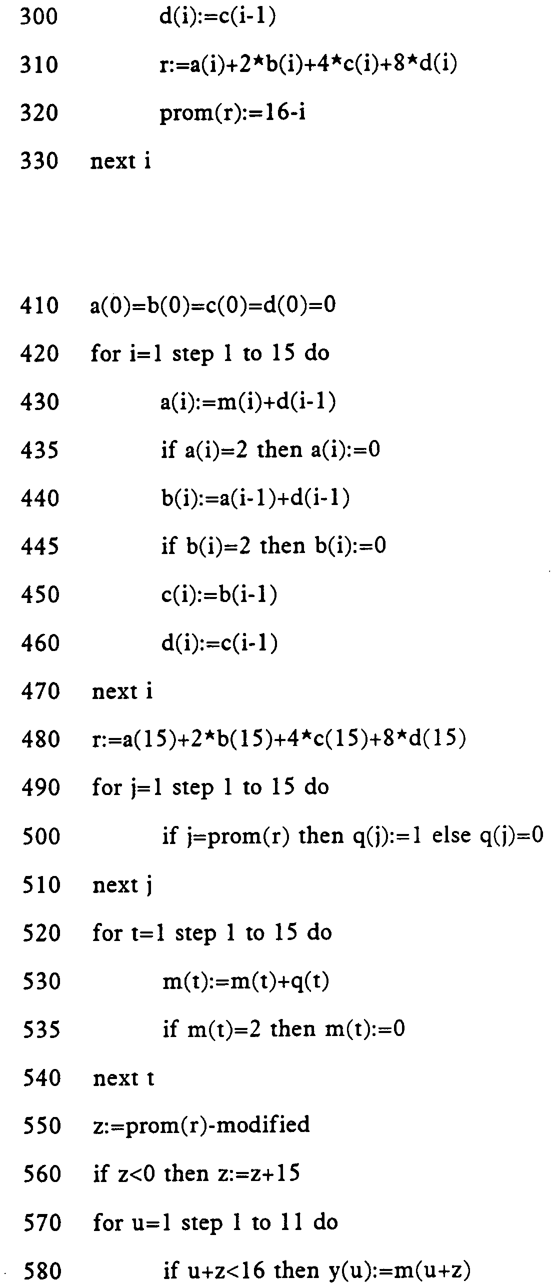 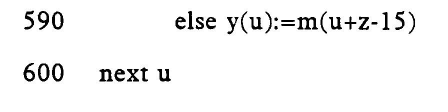
In this connection, a code word of fifteen bits m(1) to m(15) inclusive which is to be fed into an input 20 is decoded in accordance with the diagram of Figure 2 and thereby converted into a code word of eleven bits y(1) to y(11) inclusive in which the alteration introduced at a fixed position is corrected. In this implementation, said alteration is corrected by adding a word of fifteen bits q(1) to q(15) inclusive with fourteen bits being equal to zero and one bit being equal to one to the obtained code word m(1) to m(15) inclusive.

The contents of table memory 27 has to be loaded only once (lines 210 to 330 inclusive). Before starting the decoding, the contents of delay element 8, i.e. a(0) is set equal to zero, the contents of delay element 10, i.e. b(0) is set equal to zero, the contents of delay element 11, i.e. c(0) is set equal to zero and the contents of delay element 12, i.e. d(0) is set equal to zero (line 410). Then for fifteen shifts the contents of each of the delay elements 8, 10, 11 and 12 is determined (lines 420 to 470 inclusive). Table memory 27 converts the four bit input word a(15)b(15)c(15)d(15) with d(15) being the MSB into a fifteen bit output word q(15)q(14)....q(2)q(1) with q(1) being the MSB by calculation of the value r and the assignment of the value one to the bit q(j=prom(r)) and the assignment of the value zero to the bit q(j<prom(r) or j>prom(r)). This output word q(1) to q(15) inclusive is situated in the shift register 28 (lines 480 to 510 inclusive) and is added to the code word m(1) to m(15) inclusive located in shift register 30 via word adder 29 (lines 520 to 540 inclusive). Arithmetic unit 32 calculates the value z=prom(r)-modified, with modified being equal to the position where the alteration has been introduced immediately after coding, which value z = prom(r)-modified must possibly be increased by fifteen in order to prevent negative values of z (lines 550 and 560). As a matter of fact, the value z = prom(r)-modified determines the number of necessary shifts (to the right side, i.e. the MSB side) by shift register 31. Said shifting occurs by subsequently giving the bits of the word y(1) to y(11) inclusive the bit values of the eleven bits which to a certain degree are situated in a shifted manner and which belong to the fifteen bits of the code word m(1) to m(15) inclusive corrected by addition.

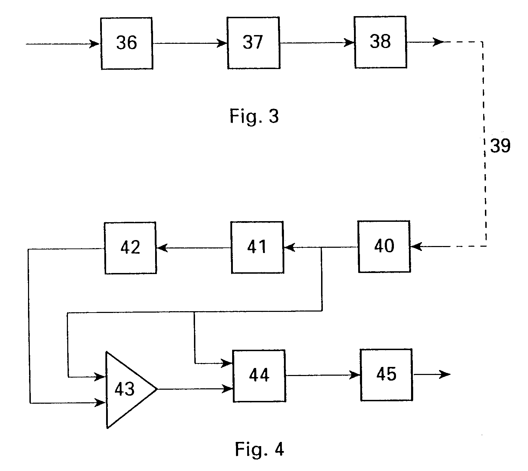

The general encoder in accordance with the invention symbolically shown in Figure 3 comprises encoding means 36 for coding words in a cyclic manner, first means 37 for introducing at least one alteration in at least one word which has been coded in a cyclic manner, and further encoding means 38 for further coding a word which has been coded in a cyclic manner. Embodiments of encoding means 36 and first means 37 have already been shown more in detail in Figure 1. Further encoding means serve 38 for the correction of flips (bit transitions) occurring in a duct 39 and erasures (bit losses) and have to code further, in a cyclic manner with a large error correcting capacity, the words which have already been coded in a cyclic manner and which has been provided with the alteration. The cyclic shifts occurring in duct 39 are, as described earlier on, annulled by using the combination of encoding means 36 and first means 37.

The general decoder in accordance with the invention, shown in Figure 4, comprises further decoding means 40 for further decoding a word which has been coded in a cyclic manner and which after that has been coded further, decoding means 41 for decoding words which have been coded in a cyclic manner, second means 42 + 43 + 44, and decoding means 45 for decoding the words which have been coded in a cyclic manner. Second means 42 + 43 + 44 further still comprise encoding means 42 for coding in a cyclic manner a word which has been coded in a cyclic manner and then has been decoded by one of the decoding means 41, comparison means 43 for comparing a word which has been coded in a cyclic manner by the still further encoding means 42 with a word which has been coded in a cyclic manner and fed into the decoding means 41, and generating means 44 for generating the alteration in response to a comparison result originating from one of the comparison means 43. Further decoding means 40 correspond with the further encoding means 38 shown in Figure 3, and decoding means 41 correspond with the encoding means 36, shown in Figure 3. Still further decoding means 45 preferably correspond with decoding means 41 and correspond with still further encoding means 42 which are preferably correspond with the encoding means 36 shown in Figure 3. Embodiments of decoding means 41 (and therefore preferably also still further decoding means 45) have already been shown more in detail in Figure 2. Embodiments of still further encoding means 42 have, when identical with encoding means 36, already been shown more in detail in Figure 1.

Assuming that flips and erasures have already been corrected by using further encoding means 38 and further decoding means 40, a word which has been coded in a cyclic manner and which has been provided with the alteration appears at the input of decoding means 41, which, owing to the minimum mutual distance with the value three, decode said coding word in such manner that the alteration introduced is automatically corrected. As a result of the cyclic shift which occurred in the duct, however, said decoded code word will be equal to a shift of the original word presented to the input of encoding means 36. By again coding the decoded code word via the still further encoding means 42 and comparing the thus obtained code word via comparison means 43 with the code word presented at the input of decoding means 41 which contains the alteration, comparison means 43 are able to generate a comparison result which is representative for the position of the alteration. On the one hand, this comparison result is fed into generating means 44, and, on the other hand, the code word presented at the input of the decoding means is also fed into said generating means 44; as a result of combining both presented signals said generating means 44 can generate the alteration and take into account said alteration in the code word, which then is decoded by still further decoding means 45 to a word which is exactly equal to the original word presented to the input of encoding means 36. In this connection, generating means 44 basically correspond with the combination, shown in Figure 2, of table memory 27, shift register 28, shift register 30, word adder 29, shift register 31 and arithmetic unit 32.

The influence of cyclic shifts on code words can thus be annulled by using all sorts of possible decoding means, also those which are only capable of automatically correcting the alteration introduced without at the same time informing the outside world about the position of the alteration concerned. It will be obvious from Figure 4 that this is especially made possible by using an extra coding and decoding step in the decoder. One of the reasons that this additional step is not present in the decoder shown in Figure 2, is that the encoder shown in Figure 1 codes in a so-called systematic manner, as a result of which the decoder shown in Figure 2 only has to decode a so-called systematic code.

## Claims

1. A system comprising an encoder which is provided with encoding means for coding words in a cyclic manner and comprising a decoder which is provided with decoding means for decoding words which have been coded in a cyclic manner, characterised in that, the encoder is provided with first means for introducing at least one alteration in at least one word which has been coded in a cyclic manner, with the decoder being provided with second means for detecting the alteration.

2. A system in accordance with claim 1, characterised in that, the encoder is provided with further encoding means for further coding a word which has been coded in a cyclic manner, with the decoder being provided with further decoding means for further decoding a word which has been coded in a cyclic manner and which after that has been coded further.

3. A system in accordance with claim 1 or 2, characterised in that, the second means of the decoder are provided with
- still further encoding means for coding in a cyclic manner a word which has been coded in a cyclic manner and which has been decoded by the decoding means,
- comparison means for comparing a word which has been coded in a cyclic manner by the still further encoding means, with a word which has been coded in a cyclic manner and which has been fed into the decoding means, and
- generating means for generating the alteration in response to a comparison result originating from the comparison means.

4. An encoder provided with encoding means for coding for coding words in a cyclic manner, characterised in that, the encoder is provided with first means for introducing at least one alteration in at least one word which has been coded in a cyclic manner, said alteration being indicative for an initial position.

5. An encoder in accordance with claim 4, characterised in that, the encoder is provided with further encoding means for further coding a word which has been coded in a cyclic manner.

6. A decoder provided with decoding means for decoding words which have been coded in a cyclic manner, characterised in that, the decoder is provided with second means for detecting at least one alteration introduced in at least one word which has been coded in a cyclic manner, said alteration being indicative for an initial position.

7. A decoder in accordance with claim 6, characterised in that, the decoder is provided with further decoding means for further decoding a word which has been coded in a cyclic manner and which after that has been coded further.

8. A decoder in accordance with claim 6 or 7, characterised in that, the second means of the decoder are provided with
- still further encoding means for coding in a cyclic manner a word which has been decoded by the decoding means,
- comparison means for comparing a word which has been coded in a cyclic manner by the still further encoding means, with a word which has been coded in a cyclic manner and which has been fed into the decoding means, and
- generating means for generating the alteration which is indicative for an initial position, in response to a comparison result originating from the comparison means.

9. A method for assigning, at a sending side, a word which has been coded in a cyclic manner to an object and for detecting, at a receiving side, the word which has been assigned to the object and which has been coded in a cyclic manner, characterised in that, the method comprises the following steps of
- coding in a cyclic manner, at the sending side, a word which is to be assigned to the object,
- introducing, at the sending side, at least one alteration in the word which has been coded in a cyclic manner,
- assigning, at the sending side, to the object the word which has been coded in a cyclic manner and which has been provided with the alteration,
- decoding, at the receiving side, the word which has been assigned to the object and which has been coded in a cyclic manner and which has been provided with the alteration, and
- detecting, at the receiving side, the alteration.

10. A method in accordance with claim 9, characterised in that, the method further comprises the following steps of
- further coding, at the sending side, a word which has been coded in a cyclic manner, and
- further decoding, at the receiving side, a word which has been coded in a cyclic manner and which after that has been coded further.

11. A method in accordance with claim 9 or 10, characterised in that, the method still further comprises the following steps of
- coding in a cyclic manner, at the receiving side, a decoded word,
- comparing, at the receiving side, a decoded word which has been coded in a cyclic manner, with a word which has been coded in a cyclic manner, and
- generating, at the receiving side, the alteration in response to a comparison result.

12. An object provided with a word which has been coded in a cyclic manner in which at least one alteration has been introduced, said alteration being indicative for an initial position.
